(19) **Europäisches Patentamt**

**European Patent Office**

**Office européen des brevets**

(11) **EP 0 622 898 B1**

(12) **EUROPÄISCHE PATENTSCHRIFT**

(45) Veröffentlichungstag und Bekanntmachung des Hinweises auf die Patenterteilung:
**14.06.2000 Patentblatt 2000/24**

(51) Int. Cl.[7]: **H03H 17/06**, H03H 17/02

(21) Anmeldenummer: **94104344.0**

(22) Anmeldetag: **19.03.1994**

(54) **Nichtrekursives Halb-Band-Filter**

Non-recursive half-band filter

Filtre à demi-bande non récursif

(84) Benannte Vertragsstaaten:
**AT CH ES GB IT LI**

(30) Priorität: **27.04.1993 DE 4313772**

(43) Veröffentlichungstag der Anmeldung:
**02.11.1994 Patentblatt 1994/44**

(73) Patentinhaber: **ROBERT BOSCH GMBH**
**70442 Stuttgart (DE)**

(72) Erfinder:
• **Auer, Erich, Dr.**
  **D-74354 Besigheim (DE)**
• **Battenschlag, Peter**
  **D-70736 Fellbach (DE)**

(56) Entgegenhaltungen:
**EP-A- 0 279 208**        **DE-A- 3 610 195**

EP 0 622 898 B1

**Beschreibung**

Die Erfindung bezieht sich auf ein Nichtrekursives Halb-Band-Filter gemäß Oberbegriff des Patentanspruchs 1 beziehungsweise 2.

Solche Filter sind bekannt, beispielsweise durch die Deutsche Patentschrift 37 05 209 beziehungsweise durch die Deutsche Patentschrift 36 10 195.

Halb-Band-Filter können je nach Anforderung an die Filtercharakteristik bei hohem Filtergrad und je nach Wortbreite des zu übertragenden Signals eine sehr umfangreiche Komplexität erreichen, welche sich in Chipflächenbedarf und Leistungsaufnahme des Chips ausdrücken. Insbesondere bei Einsatz in Vielkanalsystemen z.B. in Digitalen Filterbänken und Digitalen Filterbäumen nach der Hierarchischen Multistufen Methode (HMM), kann eine große ASIC-Fläche zustande kommen, die einen Leistungsbedarf hat, der insbesondere bei Satellitennutzlasten unerwünscht ist.

Der vorliegenden Erfindung lag die Aufgabe zugrunde, ein nichtrekursives Halb-Band-Filter der eingangs genannten Art anzugeben, welches weniger Elemente und damit weniger Fläche und weniger Leistung benötigt, die gestellten Forderungen jedoch hundertprozentig erfüllen kann.

Diese Aufgabe wurde gelöst mit den Mitteln des Anspruches 1, 2 bzw. 3. Vorteilhafte Ausgestaltungen ergeben sich durch die Unteransprüche.

Durch das erfindungsgemäße Halb-Band-Filter ergeben sich die Vorteile eines wesentlich geringeren Gatterbedarfs, welcher eine geringere Chipfläche und eine niedrigere Leistungsaufnahme nach sich zieht.

Gemäß Anspruch 1 erfolgt die Ausnutzung des Filterarithmetikteils des Halb-Band-Filters im Zeitmultiplex, das heißt reale und imaginäre Datenteile werden sequentiell verarbeitet. Eine solche Anordnung führt zu einer hundertprozentigen Ausnutzung des Arithmetikteils und zu einer fünfzigprozentigen Verringerung des Hardware Aufwandes.

Gemäß Anspruch 2 erfolgt eine Mehrfach-Ausnutzung eines Halb-Band-Filters in einem Digitalen Filterbaum nach der hierarchischen Multistufen Methode, indem die Halb-Band-Filter im Zeitmultiplex betrieben werden. Die Filterzelle gibt dabei den Hochpaß- und den Tiefpaßanteil eines Eingangsspektrums sequentiell aus. Im Falle gemultiplexter Halb-Band-Filter ergibt sich am Filterausgang eine Folge von Teilspektren unterschiedlicher Eingangsspektren, weshalb ein nachfolgendes Halb-Band-Filter nicht direkt mit diesem Signal gespeist werden kann, da es zwei aufeinanderfolgende Daten des gleichen Teilspektrums benötigt. Mit Hilfe eines Zwischenspeichers oder aber auch mit einem zwischengeschalteten Eingangsmultiplexer wird dann die richtige Datenreihenfolge für das nachfolgende Halb-Band-Filter erzeugt.

Anspruch 3 stellt die Kombination von Anspruch 1 und 2 dar.

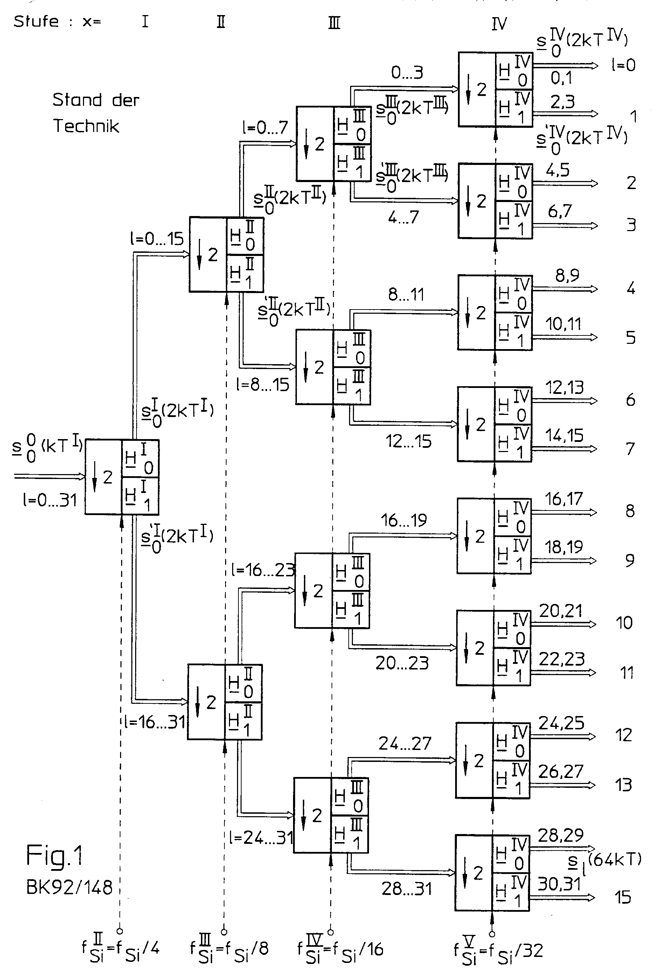

Die Erfindung wird nun anhand der Figuren näher erläutert. Die Figur 1 zeigt einen digitalen Filterbaum nach dem Stande der Technik, wobei in jeder Filterstufe die Abtastrate halbiert wird und die Anzahl der Teilspektren verdoppelt wird. Von der Spitze aus gesehen verdoppelt sich also bei diesem digitalen Filterbaum mit jeder weiteren Stufe die Anzahl der eingesetzten Halb-Band-Filter.

In Figur 2 ist ein Halb-Band-Filter im Blockschaltbild nach dem Stande der Technik wiedergegeben.

Die Figuren 3 und 5 zeigen die erfindungsgemäße Ausführung der Halb-Band-Filter für die Stufe 1 beziehungsweise 2 des digitalen Filterbaumes nach Figur 1.

In Figur 4 ist die Vergrößerung eines Blockschaltbildes für einen ab Stufe 2 vor das Halb-Band Filter einzufügenden Datenmultiplexers wiedergegeben.

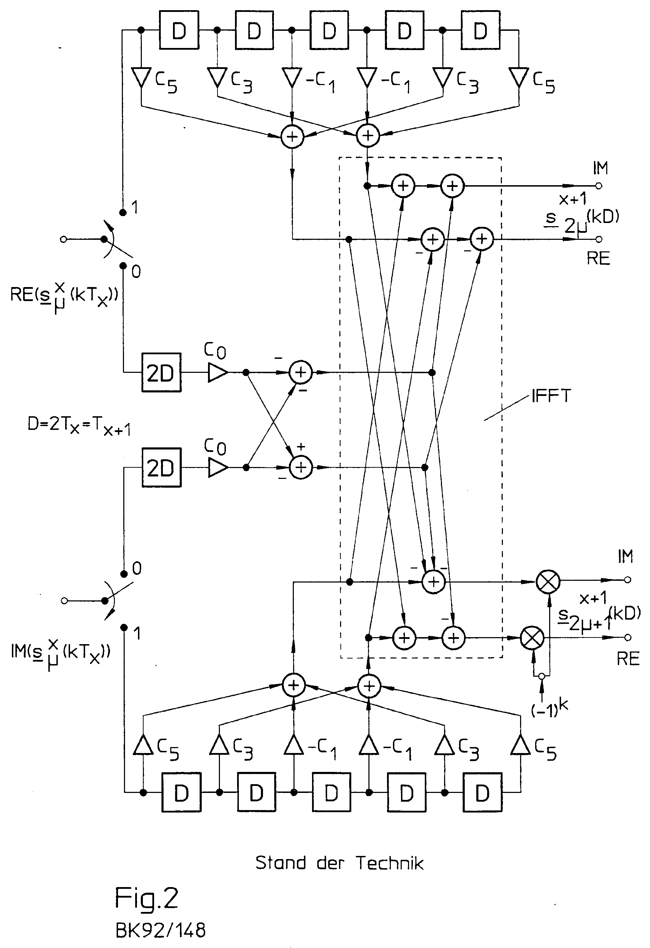

Bei dem in Figur 2 gezeigten Systementwurf eines komplexwertigen Halb-Band-Filters nach dem Stande der Technik sind links die Eingänge für den Realteil und den Imaginärteil des komplexen Eingangssignals erkennbar. Sie werden über einen Kommutator alternierend in zwei Verzögerungsketten eingespeist, wonach eine Koeffizientenmultiplikation und Zusammenfassung erfolgt, ehe eine Verknüpfung der sechs Produktsummen mittels einer inversen Fourier Transformation IFFT erfolgt, welche jeweils Realteil und Imaginärteil der beiden Teilspektren erzeugt. Bei dem oberen Teilspektrum muß noch eine Umsetzung durch Multiplikation mit $(-1)^k$ in das Basisband erfolgen. Bei dem gezeichneten Halb-Band-Filter handelt es sich um ein Filter mit dem Grad N = 6.

Dieses Halb-Band-Filter dezimiert also ein komplexwertiges Eingangssignal um den Faktor 2 und zerlegt das Eingangsspektrum dabei in einen Tiefpaß- und einen Hochpaßanteil, das heißt es handelt sich hierbei um ein Weichenfilter. Die Signale der beiden Teilspektren besitzen die halbe Abtastrate im Vergleich zu dem des Eingangsspektrums, das heißt pro Zeiteinheit wird daher die gleiche Anzahl Daten angeliefert wie ausgegeben. Der eingangsseitige Kommutator sorgt dafür, daß die Eingangsdaten abwechselnd in eine Verzögerungskette für geradzahlige und ungeradzahlige Abtastwerte eingespeist werden. Sind zwei komplexwertige Daten angeliefert worden, so beginnt die Zelle ein Datum des Tiefpaßspektrums und eine des Hochpaßspektrums zu berechnen. Da erst nach dem Eintreffen jeden zweiten Datums gerechnet wird, arbeitet die Zelle nur jeden zweiten Taktzyklus, und der Arithmetikteil der Zelle ist nur halb ausgenutzt.

Die erfinderische Idee ist, den Real- und Imaginärteil eines Datums sequentiell zu verarbeiten und damit kontinuierlichen Betrieb der Filterarithmetik unter Ausnutzung der Symmetrieeigenschaften der Filterkoeffizienten für das Hochpaßfilter und das Tiefpaßfilter zu ermöglichen (die Koeffizienten unterscheiden sich lediglich im Vorzeichen).

EP 0 622 898 B1

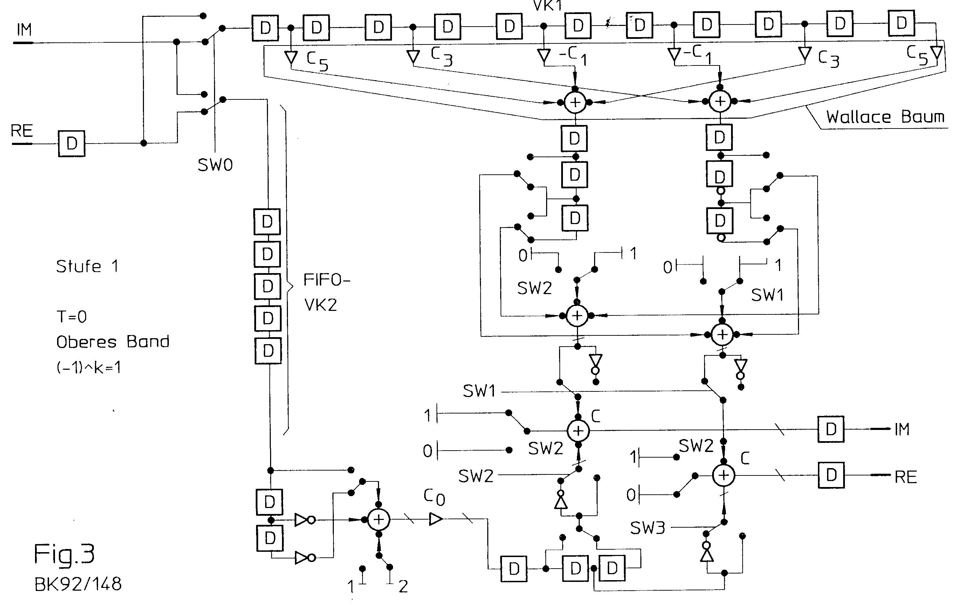

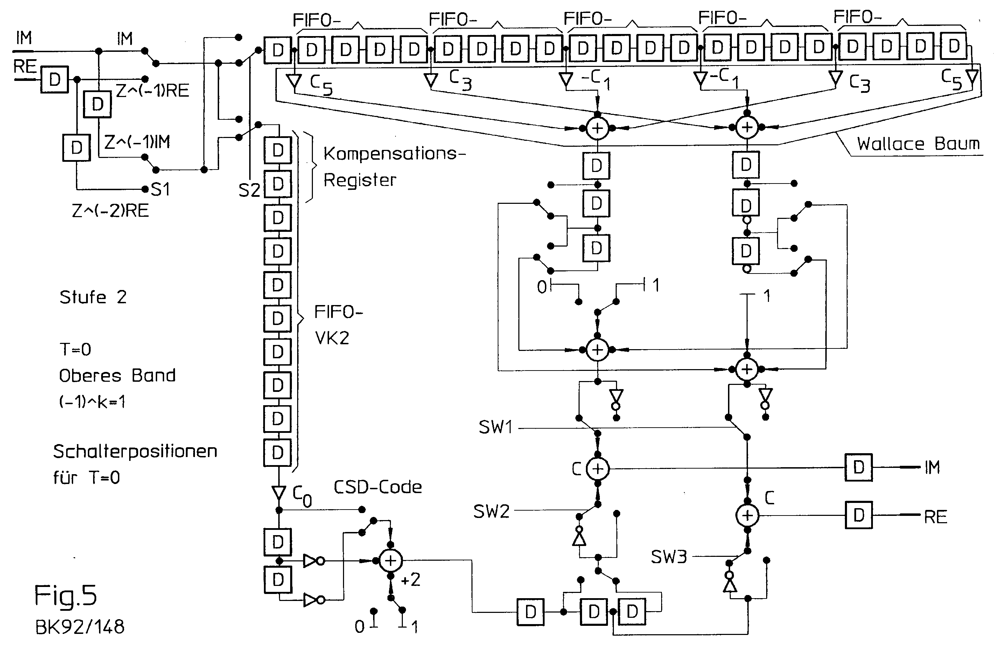

Durch diese Vorgehensweise kann der Hardware Aufwand für den Arithmetikteil fast um den Faktor 2 reduziert werden. Für einen sequentiellen Betrieb ist es allerdings erforderlich, daß jedes Register in den Verzögerungsketten VK1, VK2 gedoppelt wird, damit Real- und Imaginärteil eines Datums nacheinander eingespeist werden können; diese Verdoppelung ist aus Figur 3 aber auch aus Figur 5 ersichtlich. Der Kommutator am Filtereingang (siehe Figur 2) wird ersetzt durch einen Multiplexer, der sequentiell auf den Realteil und den Imaginärteil eines Datums zugreift. Durch diesen Multiplexer wird auch gleichzeitig die zweite Verzögerungskette VK2, welche lediglich der Speisung des Koeffizienten c0 dient, mit Real- und Imaginärteil des vorhergehenden Datums gespeist.

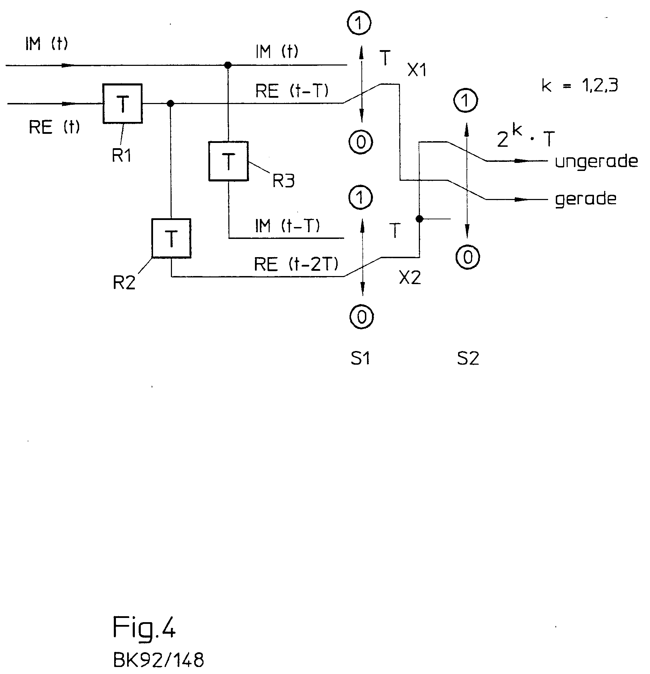

Wie aus Figur 3 erkennbar, werden die Ergebnisse, die außerhalb der mit IFFT bezeichneten Struktur berechnet werden, in eine Pipeline (eine Daten verteilende Pipeline ist in Fig. 4 im Detail sowie in Fig. 5 oben links wiedergegeben) eingespeist, damit sie für zwei aufeinander folgende Taktzyklen zur Verfügung stehen. Sie werden ja zur Berechnung des Tiefpaß- und des Hochpaßanteils benötigt. Mittels mitlaufender Multiplexer wird erreicht, daß zweimal auf das gleiche Datum zugegriffen werden kann.

Der anschließende Arithmetikteil liefert dann abwechselnd das Hochpaß- beziehungsweise das Tiefpaßsignal am Ausgang. Unterschiedliche Vorzeichen bei Additionen werden durch Komplementbildung mittels Inversion und Vorbelegung des Carryeingangs mit 1 eines nachfolgenden Addierers erreicht. Wie weiter oben schon geschildert, muß im Gegensatz zur Berechnung des Tiefpaßsignals das Hochpaßsignal noch in die Tiefpaßlage geschoben werden, was durch Multiplikation mit $(-1)^k$ am Ausgang der Filterzelle nach Figur 2 erfolgt. Diese Multiplikation wurde bei der erfindungsgemäßen Zelle in den Arithmetikteil geschoben und vor den letzten Summationspunkt C gelegt, um die Komplementbildung wie zuvor beschrieben nutzen zu können.

Wie weiter vorne schon ausgesagt wird die Abtastrate der Daten aufeinanderfolgender Hierarchieebenen sukzessiv um den Faktor 2 dezimiert, was bedeutet, daß das gesamte Datenaufkommen also die Summe der Daten aller Teilspektren pro Zeiteinheit über alle Hierarchieebenen konstant ist. Deshalb können die Halb-Band-Filter nach der ersten Stufe des digitalen Filterbaumes im Zeitmultiplex betrieben werden. Dieser Vorgehensweise steht jedoch die Notwendigkeit entgegen, daß ein Halb-Band-Filter mit zwei Daten des gleichen Teilspektrums gespeist werden muß, um eine weitere Unterteilung des Spektrums vornehmen zu können. Betrachtet man den Filterausgang der ersten Stufe nach Figur 3, so ist dort eine folgende Datenfolge festzustellen:

A(0), B(0), A(1), B(1), A(2), B(2) usw., d.h. abwechselnd ein Abtastwert im oberen und ein Abtastwert im unteren Band. Der Eingang der Halb-Band-Filters der nächsten Stufe gemäß Figur 5 benötigt aber eine Datenfolge

A(0), A(1), B(0), B(1) usw.

Es läßt sich leicht erkennen, daß mit dieser Zeitmultiplexrealisierung des Filters ein Zwischenspeicher erforderlich ist, um das nachfolgende Halb-Band-Filter zu speisen.

Um größere Speicherstrukturen zu umgehen, wie sie insbesondere in tieferen Hierarchiestufen notwendig werden, wird von einem Freiheitsgrad für die Realisierung Gebrauch gemacht. Das Halb-Band-Filter kann mit einem Phasenoffset von einem Abtastintervall gespeist werden, das heißt es existiert kein Zeitbezug zwischen den Eingangsmultiplexern am Filtereingang und dem tatsächlichen Abtastintervall. Dieser Freiheitsgrad kann nun für unterschiedliche Signale unterschiedlich genutzt werden, z.B. ist folgende Filtereingangssequenz möglich:

A(0), A(1), B(1), B(2), A(2), A(3), B(3), B(4)

(mit A beziehungsweise B sind die Abtastwerte des Spektrums A beziehungsweise B bezeichnet).

Relativ zu A wird das Zeitsignal B also mit einem Phasenoffset von einem Abtastintervall in das Filter eingespeist.

Die Ausnutzung dieses Freiheitsgrads schlägt sich in der in Figur 4 gezeigten Eingangsmultiplexerstruktur nieder. Diese besteht aus 3 Registern und 4 Multiplexer-Schaltern S1, S2, die paarweise geschaltet werden. Register R1 verzögert den Realteil eines Datums um ein Abtastintervall, um so Real- und Imaginärteil eines Datums sequentiel verarbeiten zu können. Zwei weitere Register, R2, R3, dienen dazu, um ein vorangegangenes komplexwertiges Datum für zwei weitere Abtastintervalle zur Verfügung zu haben.

Funktion: Multiplexer-Schalter S1 selektiert abwechselnd Imaginär- und Realteil zweier aufeinanderfolgender Daten, Schalter S2 verteilt diese Daten in die beiden Verzögerungsketten. Während Imaginär- und Realteil des Teilspektrums A in der Verzögerungskette VK1 eingespeist werden, wird die Verzögerungskette VK2 mit Imaginär- und Realteil des Teilspektrums B gespeist, das mit Teilspektrum A zeitlich alterniert. Betrachtet man die Signale x1, x2, so erscheinen dort nur Imaginär- und Realteil der Daten jedes zweiten Teilspektrums. Schalter S2 sorgt nun dafür, daß eine alternierende Verteilung dieser Daten in die beiden Verzögerungsketten erfolgt, Schalter S2 arbeitet also in der 2. Hierarchiestufe mit der halben Abtastfrequenz. In den folgenden Hierarchiestufen wird dessen Schalterfrequenz jeweils halbiert, da sich die Anzahl der Teilspektren entsprechend verdoppelt.

Durch diese Anordnung werden gleichzeitig Daten unterschiedlicher Teilspektren in verschiedene Verzögerungsketten eingespeist, vergleiche Figur 5. Um den korrekten zeitlichen Bezug innerhalb der Filterstruktur beizubehalten, müssen zusätzliche Register in eine der Verzzögerungsketten eingebaut werden. Die Anzahl der Register richtet sich nach der Tiefe der Hierarchie. In der obersten Hierarchie entfallen der Umschalter und die Register vollständig. In allen weiteren Stufen der Hierarchie gilt, daß die Anzahl der Register die Hälfte der Teilspektren kompensieren muß (Real- und Imaginärteil.)

**Patentansprüche**

1. Nichtrekursives Halb-Band-Filter mit komplexen Koeffizienten zum Verarbeiten eines komlexwertigen Eingangssignals s(kT) unter Verminderung der Abtastfrequenz fA = 1/T und zum Umwandeln dieses komplexwertigen Eingangssignals $\underline{s}$(kT) in ein komplexwertiges Ausgangssignal $\underline{s}$(2kT), wobei seine Impulsantwort h(I), mit I = -(N - 1)/2 bis (N - 1)2 und der ungeraden Filterlänge N, auf den komplexen Träger einer Frequenz von + 1/4 der Abtastfrequenz fA = 1/T moduliert wird zu

$$\underline{h}(I) = h(I) \cdot e^{j(\pm 2\pi fA/4fA)+\phi 0)} = j\pm^{I} \cdot e^{j\phi 0} \cdot h(I)$$

und wobei die Nullphase $\phi$ dieses komplexen Trägers ganze Vielfache m von $\pi$/2 beträgt, $\phi 0 = m \cdot \pi$/2
mit m = 0, 1, 2, 3,...,
wobei sein komplexwertiges Eingangssignal $\underline{S}_{(kT)} = S_{1r} + js_{1i}$ mittels Faltung mit der modulierten Impulsantwort $\underline{h}$(I) in das komplexwertige Ausgangssignal

$$s(2kT) = s_1(2kT)*h(I)$$
$$\underline{=} s_{1r}(2k)*h_r(I)-s_{1r}(2k)*h_i(I)+j[s_{1r}(2k)*h_i(I)+s_{1r}(2k)*h_r(I)] \qquad (1)$$

mit k als laufendem Index umgewandelt wird,
k =... - 1, 0, 1,...,
wobei Realteil und Imaginärteil des Eingangssignals jeweils in gleiche Teil-Filter gespeist werden, wobei diese Teil-Filter jeweils aus einem Eingangsdemultiplexer mit M Stellungen besteht, wobei in jeder Stellung eine Kette von höchstens 〈N/M〉 Verzögerungsglieder der Verzögerungszeit M $\cdot$ T speisbar ist und 〈N/M〉 die nächstkleinere ganze Zahl angibt, wenn N/M keine ganze Zahl ist, wobei der Eingangsdemultiplexer die mit der Abtastrate fA gelieferten Werte des Eingangssignals zyklisch jeweils auf aufeinanderfolgenden Ketten
$\mu$ = 0,1 ... M - 1, 0, 1, ... verteilt, so daß die Eingangssignalfolge in M Teilfolgen der auf fA/M verminderten Abtastrate aufgeteilt wird, wobei die verschiedenen Abtastwerte der M Teilfolgen mit Koeffizienten h($\sqrt{}$) $\sqrt{}$ = 0, 1, ... N - 1 multipliziert werden,
so daß für die $\mu$-te Teilfolge folgende Produkte entstehen:

$$P(\mu) = s\mu(kM - \sqrt{M}) \cdot h(\mu + \sqrt{M}), \sqrt{} = 0, 1, 2, ...,$$

wobei jeweils die Produkte P($\mu$, M) zu komplexen Zwischensignalen zusammengefaßt werden,
dadurch gekennzeichnet,
daß nur ein einziges Halb-Band-Teil-Filter vorgesehen ist, in das Realteil und Imaginärteil des Eingangssignals zeitlich versetzt eingespeist werden, und
daß die Anzahl der Verzögerungsglieder verdoppelt ist zur sequentiellen Aufnahme und Zwischenspeicherung von abwechselnd Real- und Imaginärteil.

2. Nichtrekursives Halb-Band-Filter nach dem Oberbegriff des Anspruchs 1, verwendet in einem digitalen Filterbaum, bestehend aus mehreren digitalen Filterbänken, die in einer Baumstruktur stufenweise sich verzweigend hintereinander angeordnet sind, wobei ausgehend von der 1. Stufe, Baumspitze, in der $\nu$-ten Stufe,
$\nu$ = 1, 2, ..., eine Separierung in $L_\nu$ Einzelsignale erfolgt,
wobei in der $\nu$-ten Stufe die Abtastrate jeweils um den Faktor $M_\nu \le L_\nu$ vermindert wird, Hierarchische Multistufen-Methode, HMM, wobei die einzelne digitale Filterbank zur frequenzmäßigen Trennung eines mit der Abtastfrequenz fA abgetasteten aus höchstens $L_\nu$ Einzelsignalen der Bandbreite B zusammengesetzten Frequenzmultiplexsignals dient, wobei in einem Prototyp-Filter Produktsummen

$$\underline{v}(k,q) = \sum_{p=-\infty}^{+\infty} \underline{s}_\nu(k-i) \cdot \underline{h}(i) \cdot e^{j\pi i/L}$$

mit

i = p $\cdot$ L + q und

q = 0, 1, 2, ... L-1,

i, p, q = {0, 1, 2, 3, ...},

aus dem mit der Abtastfrequenz fA = 1/T abgetasteten Eingangssignals $\underline{s}_v$ (k), der endlich langen Impulsantwort $\underline{h}$ (i) für i = 0, 1, 2, ... , N-1 des Prototyp-Filters und mit einem komplexen Drehfaktor einer Diskreten Fourier-Transformation, DFT, zur Bildung von L komplexen Ausgangssignalen

$$\underline{s}l_v\ (kM) = \sum_{q=0}^{L_v-1} \underline{v}_v\ (km,q)\ \cdot\ e^{j2\pi ql/L} = DFT\ \{\underline{v}_v\ (kM,q)\}$$

unterworfen sind, wobei die Verminderung der Abtastrate um den Faktor $M_v \leq L_v$ so erfolgt, daß nur jeder M-te Wert der Produktsummen in der DFT bearbeitet wird, für Kanalmittenfrequenzen fl = l $\cdot$ $B_v$ + $B_v$/2 , wobei 1 die laufende Nummer des Kanals mit 0, 1, 2, ... $L_v$-1 und $B_v$ die Kanalbandbreite sind, wobei das eingangsseitige Frequenzmultiplexsignal

$\underline{s}_D$ (k $\cdot$ $T_v$) = sr$_v$ (kT$_v$) + j $\cdot$ si$_v$ (kT$_v$) in Form zweier voneinander unabhängiger, zeitabhängiger Signalfolgen sr$_v$ (kT$_v$) und si$_v$ (kT$_v$) eingespeist wird, wobei die erste Folge als Realteil Re = sr$_v$ (kT$_v$) und die zweite Folge als Imaginärteil Im = si$_v$ (kT$_v$) der komplexwertigen, zeitabhängigen Eingangsgröße gilt und wobei j = $\sqrt{-1}$ und der Zeitfaktor k = ...-1, 0, +1,... sind, wobei für die Filterung des Realteils sr$_v$ und des Imaginärteils si$_v$ jeweils eine Kette von N-1 Verzögerungsgliedern der Verzögerungszeit $T_{v+l}$ verwendet wird, wobei die Abtastung des Inhalts der einzelnen unterschiedlich verzögerten Signalwerte der Teilfolge beider Ketten jeweils mit einer Rate erfolgt, die um den Faktor $M_v \leq L_v$ vermindert ist, wobei diese so abgetasteten Signalwerte für Real- und Imaginärteil jeweils mit den Koeffizienten $\underline{h}$(i) multipliziert werden, wobei für Real- und Imaginärteil jeweils die Ausgänge der $L_v$-ten Multiplizierer zu $L_v$Produktsummen, nämlich den komplexen Zwischensignalen $\underline{v}_v$ (kM,q) vor der Diskreten Fourier-Transformation, DFT, jeweils mit komplexen Koeffizienten $e^{j\pi q/L}$ multipliziert werden, dadurch gekennzeichnet, daß für jede Stufe des Baumes nur ein einziges Halb-Band-Filter vorgesehen ist, das gemultiplext wird, und daß der Multiplex-Daten-Prozeß innerhalb des Halb-Band-Filters für die verschiedenen Subbänder der jeweiligen Stufe erfolgt.

3. Halb-Band-Filter nach dem Oberbegriff des Anspruches 2, dadurch gekennzeichnet,
daß für jede Stufe des Baumes nur ein einziges Halb-Band-Teil-Filter, HMM-Zelle, vorgesehen ist, das gemultiplext wird, und daß der Multiplex-Daten-Prozeß innerhalb des Teil-Filters für Imaginär- und Realteil und für die verschiedenen Subbänder der jeweiligen Stufe erfolgt.

4. Halb-Band-Filter nach einem der vorhergehenden Ansprüche, dadurch gekennzeichnet,
daß die Verzögerungsgliederketten durch eine FIFO-Speicherstruktur implementiert ist.

5. Halb-Band-Filter nach Anspruch 2, 3 oder 4, dadurch gekennzeichnet, daß für alle Stufen $M_v$ = 2 und $L_v$ = 2 festgelegt ist.

6. Halb-Band-Filter nach Anspruch 2, 3, 4 oder 5, dadurch gekennzeichnet, daß zwischen den einzelnen Hierarchiestufen ein FIFO-Speicher oder ein Eingangsmultiplexer eingefügt ist.

**Claims**

1. Non-recursive half-band filter having complex coefficients for processing a complex-valued input signal s(kT) while reducing the sampling frequency fA = 1/T and for converting this complex-valued input signal $\underline{s}$(kT) into a complex-valued output signal $\underline{s}$(2kT), its pulse response h(l), with 1 = -(N - 1)/2 to (N - 1)2 and the odd filter length N, being modulated onto the complex carrier of a frequency of + 1/4 of the sampling frequency fA = 1/T to form

$$\underline{h}(1) = h(l)\ \cdot\ e^{j(\pm 2\pi fA/4fA) + \varphi 0)} = j\pm^1\ \cdot\ e^{j\varphi}0\ \cdot\ h(l)$$

and the zero phase $\varphi$ of this complex carrier being a whole multiple m of $\pi$/2, $\varphi 0$ = m $\cdot$ $\pi$/2 with m = 0, 1, 2, 3, etc., its complex-valued input signal $\underline{S}_{(kT)}$ = S$_{1r}$ + js$_{li}$ being converted by means of convolution with the modulated pulse response $\underline{h}$(l) into the complex-valued output signal

$$\underline{s}(2kT) = \underline{s}_1(2kT)*\underline{h}(l) \tag{1}$$
$$= s_{1r}(2k)*h_r(l)-s_{1r}(2k)*h_i(l)+j[s_{1r}(2k)*h_i(l)+s_{1r}(2k)*h_r(l)]$$

with k as running index, k = ... - 1, 0, 1, etc., the real part and imaginary part of the input signal being respectively fed into identical subfilters, these subfilters in each case comprising an input demultiplexer having M positions, it being possible in each position to feed a chain of at most ⟨N/M⟩ time-delay elements of delay time M · T, and ⟨N/M⟩ specify the next smallest whole number if N/M is not a whole number, the input demultiplexer in each case distributing the values, supplied at the sampling frequency fA, of the input signal cyclically to other sequential chains $\mu$ = 0, 1 ... M - 1, 0, 1, ..., so that the input signal sequence is divided into M subsequences of the sampling rate reduced to fA/M, the various sample values of the M subsequences being multiplied by coefficients h(√)√ = 0, 1, ... N - 1, so that the following products are produced for the u-th subsequence:

$$P(\mu) = s\mu(kM - \sqrt{M}) \cdot h(\mu + \sqrt{M}), \sqrt{} = 0, 1, 2, ...,$$

the products P($\mu$, M) in each case being combined to form complex intermediate signals, characterized in that only a single half-band subfilter is provided into which the real part and imaginary part of the input signal are fed offset in time, and in that the number of the time-delay elements is doubled for the purpose of sequential recording and buffering of the real and imaginary parts alternately.

2.  Non-recursive half-band filter according to the preamble of Claim 1, used in a digital filter tree, comprising a plurality of digital filter banks which are arranged one after another branching in stages in a tree structure, a separation into $L_v$ individual signals being performed in the v-th stage, v = 1, 2, ..., starting from the 1$^{st}$ stage, the top of the tree, the sampling rate in the v-th stage being reduced in each case by the factor $M_v \leq L_v$, the individual digital filter bank serving the purpose of frequency separation of a frequency multiplex signal sampled with the sampling frequency fA and assembled from at most $L_v$ individual signals of bandwidth B, product sums

$$\underline{v}(k, q) = \sum_{p = -\infty}^{+\infty} \underline{s}_v(k - i) \cdot \underline{h}(i) \cdot e^{j\pi i / L}$$

with

i = p · L + q  and
q = 0, 1, 2, ... L-1,
l, p, q = (0, 1, 2, 3, ...),

composed of the input signal $\underline{s}_v(k)$ sampled with the sampling frequency fA = 1/T, the infinitely long pulse response $\underline{h}(i)$ for i = 0, 1, 2, ..., N-1 of the prototype filter, and with a complex rotary factor, being subjected in a prototype filter to a discrete Fourier transformation, DFT, in order to form L complex output signals

$$\underline{s1}_v(kM) = \sum_{q=0}^{Lv-1} \underline{v}_v(km, q) \cdot e^{j2\pi ql / L} = DFT \left\{ \underline{v}_v(kM, q) \right\}$$

the reduction in the sampling rate by the factor $M_v \leq L_v$ being performed such that only each M-th value of the product sums is processed in the DFT, for channel centre frequencies fl = 1 · $B_v$ + $B_v$/2 , l being the running number of the channel with 0, 1, 2, ... $L_v$ -1 and $B_v$ being the channel bandwidth, the input-side frequency multiplex signal $\underline{s}_D(k \cdot T_v) = sr_v(kT_v) + j \cdot si_v(kT_v)$ being fed in the form of two mutually independent, time-dependent signal sequences $sr_v(kT_v)$ and $si_v(kT_v)$, the first sequence serving as the real part Re = $sr_v(kT_v)$ and the second sequence serving as the imaginary part Im = $si_v(kT_v)$ of the complex-valued, time-dependent input variable, and j = √-1 and the time factor k = ...-1, 0, +1, ..., a chain of N-1 time-delay elements of the delay time $T_{v+l}$ being used in each case for filtering the real part $sr_v$ and the imaginary part $si_v$, the sampling of the contents of the individual differently delayed signal values of the subsequence of the two chains being performed in each case at a rate which is reduced by the factor $M_v \leq L_v$, these signal values thus sampled for the real and imaginary parts respectively being multiplied by the coefficients $\underline{h}(i)$, then for the real and imaginary parts the outputs of the $L_v$-th multipliers being in each case multiplied respectively by complex coefficients $e^{j\pi q/L}$ to form $L_v$ product sums, specifically the complex intermediate signals $\underline{v}_v(kM,q)$ before the discrete Fourier transformation, DFT, characterized in that only a single half-band filter which is multiplexed is provided for each stage of the tree, and in that the multiplex data process is performed within the half-band filter for the various subbands of the respective stage.

3. Half-band filter according to the preamble of Claim 2, characterized in that only a single half-band sub-filter, HMM cell, which is multiplexed is provided for each stage of the tree, and in that the multiplex data process is performed within the subfilter for imaginary and real parts and for the various subbands of the respective stage.

4. Half-band filter according to one of the preceding claims, characterized in that the chain of time-delay elements is implemented by means of an FIFO storage structure.

5. Half-band filter according to Claim 2, 3 or 4, characterized in that $M_v = 2$ and $L_v = 2$ are fixed for all stages.

6. Half-band filter according to Claim 2, 3, 4 or 5, characterized in that a FIFO memory or an input multiplexer is inserted between the individual hierarchical stages.

**Revendications**

1. Filtre à demi-bande, non récursif à coefficient complexe pour traiter un signal d'entrée complexe s(kT) en réduisant la fréquence de détection fA = 1/T et pour convertir ce signal d'entrée complexe $\underline{s}$(kT) en un signal de sortie complexe $\underline{s}$(2kT),
sa réponse impulsionnelle h($\ell$) avec $\ell$ = -(N - 1)/2 à (N - 1)/2 et avec une longueur de filtre impaire (N), étant modulée sur la porteuse complexe par une fréquence de + 1/4 de la fréquence de détection fA = 1/T pour :

$$\underline{h}(\ell) = h(\ell) \cdot e^{\,j(\pm 2\pi fA/4fA)+\varphi 0)} = j\pm^{\ell} \cdot e^{\,j\varphi}0 \cdot h(\ell)$$

et la phase nulle $\varphi$0 de cette porteuse complexe correspondant à des multiples entiers m de $\pi/2$, $\varphi_0 = m \cdot \pi/2$ avec m = 0, 1, 2, 3...,
son signal d'entrée complexe $\underline{s}$(kT) = s$_{1r}$ + js$_{1i}$, étant combiné par convolution à la réponse impulsionnelle modulée $\underline{h}(\ell)$ pour donner un signal de sortie complexe

$$\underline{s}(2kT) = \underline{s}_1(2kT){*}\underline{h}(\ell) \qquad (1)$$
$$= s_{1r}(2k){*}h_r(\ell)\text{-}s_{1r}(2k){*}h_i(\ell)+j[s_{lr}(2k){*}h_i(\ell)+s_{1r}(2k){*}h_r(\ell)]$$

avec k indice courant
k = ... - 1, 0, 1,...
la partie réelle et la partie imaginaire du signal d'entrée étant fournies chaque fois à des filtres partiels,
ces filtres partiels se composant chacun d'un démultiplexeur d'entrée à M positions,
dans chaque position on peut introduire une chaîne d'au moins 〈N/M〉, éléments de temporisation pour la durée de temporisation M•T, et 〈N/M〉, désignant le plus petit nombre entier suivant, si N/M n'est pas un nombre entier, le démultiplexeur d'entrée répartissant les valeurs fournies au taux de détection fA du signal d'entrée, de manière cyclique, chaque fois sur les chaînes successives $\mu$ = 0,1... M - 1, 0, 1,... pour que la suite des signaux d'entrée soit répartie en M suites partielles du taux de détection réduit à fA/M,
les différentes valeurs de détection des M suites partielles étant multipliées avec les coefficients h($\sqrt{}$) $\sqrt{}$ = 0, 1, ... N - 1 pour obtenir les produits suivants pour la suite partielle d'ordre $\mu$ :

$$P(\mu) = s\mu(kM - \sqrt{M}) \cdot h(\mu + \sqrt{M}), \ \sqrt{} = 0, 1, 2,...,$$

les produits P($\mu$, M) étant regroupés chaque fois en signaux intermédiaires complexes,
caractérisé par
un unique filtre partiel à demi-bande dans lequel la partie réelle et la partie imaginaire du signal d'entrée sont introduites de manière décalée dans le temps, et
le nombre des éléments de temporisation est doublé pour recevoir séquentiellement et mémoriser de façon intermédiaire, en alternance, la partie réelle et la partie imaginaire.

2. Filtre à demi-bande non récursif selon le préambule de la revendication 1 appliqué à un faisceau de filtres numériques, composé de plusieurs ensembles de filtres numériques réunis les uns à la suite des autres, de manière échelonnée, selon une arborescence, et

- partant du premier étage (sommet de l'arborescence) dans l'étage $\nu$ ($\nu = 1, 2, ...$), on effectue une séparation en $L_\nu$ signaux distincts,
- dans l'étage $\nu$, on réduit le taux de détection selon le coefficient $M_\nu \leq L_\nu$,
- l'ensemble de filtres numériques distincts réalisant la séparation en fréquence, d'un signal multiplexé en fréquence, composé au plus de $L_\nu$ signaux séparés, dans la bande B et qui sont détectés à la fréquence de détection fA,
- et dans un filtre prototype on soumet à une transformation de Fourier, discrète, TFD les sommes de produits

$$\underline{v}(k, q) = \sum_{p=-\infty}^{+\infty} \underline{s}_\nu(k - i) \bullet \underline{h}(i) \bullet e^{j\pi i / L}$$

avec :

i = p · L + q  et
q = 0, 1, 2,...L-1,
i, p, q = {0, 1, 2, 3,...},

du signal d'entrée $\underline{s}_\nu$ (k) détecté à la fréquence de détection fA = 1/T , de la réponse impulsionnelle du filtre prototype de longueur finie $\underline{h}$(i), i = 0, 1, 2,..., N-1, et d'un coefficient de rotation complexe, pour former L signaux de sortie complexes

$$\underline{s\ell}_\nu(kM) = \sum_{q=0}^{L_\nu - 1} \underline{v}_\nu(km, q) \bullet e^{j2\pi q\ell / L} = TFD\{\underline{v}_\nu(kM, q)\}$$

- la réduction du coefficient de détection selon le facteur $M_\nu \leq L_\nu$ se fait pour que seulement chaque valeur d'ordre M des sommes de produits soit traitée selon la transformation TFD, pour des fréquences centrales de canal $f\ell = \ell \cdot B_\nu + B_\nu/2$ , relation dans laquelle $\ell$ représente le nombre courant du canal avec 0, 1, 2,...$L_\nu$-1 et $B_\nu$ représente la largeur de la bande du canal,
- le signal multiplexé en fréquence, d'entrée $S_D$ (k · $T_\nu$) = $sr_\nu$ ($kT_\nu$) + j · $si_\nu$ ($kT_\nu$) est injecté sous la forme de deux suites de signaux $sr_\nu(kT_\nu)$ et $si_\nu(kT_\nu)$ dépendant du temps, ces suites étant indépendantes l'une de l'autre,
- la première suite est la partie réelle Re = $sr_\nu$ ($kT_\nu$) et la seconde suite, la partie imaginaire Im = $si_\nu$ ($kT_\nu$) des grandeurs d'entrée de valeurs complexes dépendant du temps, j = $\sqrt{-1}$ et le facteur de temps est k = ...-1, 0, +1,...,
- et pour filtrer la partie réelle $sr_\nu$ et la partie imaginaire $si_\nu$ on utilise chaque fois une chaîne de N-1 éléments de temporisation pour la durée de temporisation $T_{\nu+l}$,
- la détection du contenu des différentes valeurs de signal décalées de manière différente de la suite partielle des deux chaînes se fait chaque fois avec un taux diminué selon le coefficient $M_\nu \leq L_\nu$,
- les valeurs de signaux ainsi détectées pour la partie réelle et la partie imaginaire sont chaque fois multipliées par les coefficients $\underline{h}$(i),
- pour la partie réelle et la parcie imaginaire, les signaux de sortie du multiplicateur $L_\nu$ sont multipliés pour donner $L_\nu$ sommes de produits, à savoir ces signaux sont multipliés par les signaux intermédiaires complexes $\underline{v}_\nu$ (kM,q) avant la transformation de Fourier discrète TFD, par multiplication avec chaque fois des coefficients complexes $e^{j\pi q/L}$, caractérisé en ce que
pour chaque niveau de l'arborescence il n'est prévu qu'un seul filtre à demi-bande qui est multiplexé, et
le procédé de multiplexage des données à l'intérieur du filtre à demi-bande se fait pour les différentes sous-bandes de l'étage respectif.

3. Filtre à demi-bande selon le préambule de la revendication 2,

caractérisé en ce que

chaque niveau de l'arborescence n'a qu'un seul filtre partiel à demi-bande qui est multiplexé et
le procédé de multiplexage des données à l'intérieur du filtre partiel se fait pour la partie imaginaire et pour la partie réelle et pour les différentes sous-bandes de chaque niveau.

4. Filtre à semi-bande selon l'une quelconque des revendications précédentes,
caractérisé en ce que
les chaînes d'éléments de temporisation sont réalisées par des structures de mémoire FIFO.

5. Filtre à semi-bande selon la revendication 2, 3 ou 4,
caractérisé en ce que
pour tous les niveaux on a fixé $M_\nu = 2$ et $L_\nu = 2$.

6. Filtre selon la revendication 2, 3, 4 ou 5,
caractérisé par
une mémoire FIFO ou un multiplexeur d'entrée inséré entre les différents niveaux hiérarchiques.

Fig.1
BK92/148

EP 0 622 898 B1

Stand der Technik

# Fig.2

BK92/148

IM

VK1

RE

D

SW0

$C_5$  $C_3$  $-C_1$  $-C_1$  $C_3$  $C_5$

Wallace Baum

Stufe 1

T=0

Oberes Band

$(-1)^k=1$

FIFO–
VK2

D

D

D

D

D

SW2   0   1   SW1

SW1

1   $C$
0   SW2

SW2

$C_0$

SW2   1   $C$
0

SW3

1   2

D — IM

D — RE

Fig.3
BK92/148

IM (t)

RE (t)

R1

T

R2

T

R3

T

IM (t)

RE (t-T)

IM (t-T)

RE (t-2T)

① 

⓪

① 

⓪

T X1

T

X2

S1

① 

⓪

S2

$2^k \cdot T$

ungerade

gerade

k = 1,2,3

Fig.4
BK92/148

13

Fig.5
BK92/148

Stufe 2

T=0
Oberes Band
$(-1)^k=1$

Schalterpositionen
für T=0

EP 0 622 898 B1